# EUROPÄISCHE PATENTSCHRIFT

(11) **EP 0 510 340 B1**
(45) Veröffentlichungstag und Bekanntmachung des Hinweises auf die Patenterteilung: **10.05.1995**
(21) Anmeldenummer: 92104062.2
(22) Anmeldetag: 10.03.1992
(51) Int. Cl.: C23G 5/00, C23C 14/02

(54) **Verfahren zur Abtragung von Material von einer Oberfläche in einer Vakuumkammer**
Method for removing material from a surface in a vacuum chamber
Procédé pour retirer du matériau d'une surface dans une chambre à vide

(30) Priorität: 23.04.1991 CH 1215/91
(43) Veröffentlichungstag der Anmeldung: 28.10.1992
(73) Patentinhaber: BALZERS AKTIENGESELLSCHAFT, 9496 Balzers (LI)
(72) Erfinder: Ramm, Jürgen, Dr., CH-7306 Fläsch (CH); Beck, Eugen, FL-9497 Triesenberg (LI); Zueger, Albert, FL-9494 Schaan (LI)

(56) Entgegenhaltungen:
- EP-A- 0 282 467
- EP-A- 0 371 693
- PATENT ABSTRACTS OF JAPAN, vol. 14, no. 63 (C-685)(4006), 6. Februar 1990; & JP-A-12 87 288
- PATENT ABSTRACTS OF JAPAN, vol. 14, no. 412 (C-755)(4355), 6. September 1990; JP-A-21 56 066
- JOURNAL OF VACUUM SCIENCE TECHNOLOGY B, Bd. 8, Nr. 4, Juli 1990, Seiten 656-657; ARTHUR SHERMAN: "In situ removal of native oxide from silicon wafers"
- PATENT ABSTRACTS OF JAPAN, vol. 4, no. 173 (C-32)(655), 29. November 1980; & JP-A-55 110 771

## Beschreibung

Die vorliegende Erfindung betrifft ein Verfahren zur Abtragung von Material von einer Oberfläche in einer Vakuumkammer bei welchem plasma-aktivierter Wasserstoff verwendet wird sowie eine Anordnung zur Durchführung des Verfahrens. Bei der Beschichtung von Werkstücken ist es beispielsweise oft notwendig, die Werkstückunterlage vor der Beschichtung einem Reinigungsvorgang zu unterziehen, um die danach aufzubringende Schicht mit hoher Haftfestigkeit aufbringen zu können. Das Verfahren kann überall dort Anwendung finden, wo Werkstücke beschichtet werden sollen mit Hilfe eines Vakuumverfahrens, wie beispielsweise bei der Beschichtung von Halbleiterschaltkreisen oder beispielsweise von Werkzeugen. Im weiteren kann das Verfahren auch verwendet werden um neben Werkstücken auch die Vakuumkammer selbst von Verunreinigungen zu befreien. Das Anwendungsgebiet dieser Reinigungsmethode erstreckt sich auf das Entfernen von Verunreinigungen die aus Oxiden, Kohlenstoff und auch Kohlenstoffverbindungen bestehen, wobei die chemische Reaktivität des Wasserstoffes genutzt wird.

Bekannte Reinigungsverfahren für Werkstücke sind beispielsweise Plasmaätzverfahren und das Zerstäubungsätzen. Bei hohen Aetzraten können bei den vorerwähnten Verfahren Temperaturen von einigen 100 ° C am Werkstück auftreten. In vielen Fällen sind diese hohen Temperaturwerte für das Werkstück nicht geeignet. Zusätzlich treten relativ hohe Energiewerte der Teilchen im Bereich von einigen 10 bis einige 100 Elektronenvolt auf, mit welchen das Werkstück bearbeitet wird. Neben der hohen Temperaturbelastung kann dies zu einer Veränderung beziehungsweise zu Defekten in der Oberflächenstruktur des Werkstückes führen. Ein weiterer Nachteil der bekannten Verfahren ist, dass das Aetzverfahren selbst eine Verunreinigung des Werkstückes durch Wiederbelegung verursachen kann. Mit diesem bekannten Verfahren können höchste Reinheitsanforderungen deshalb nur begrenzt erfüllt werden.

Um diese Nachteile zu umgehen und ein schonenderes Aetzverfahren verwenden zu können, wird vorgeschlagen Siliziumoxyd mit angeregtem Wasserstoff zu ätzen gemäss der Veröffentlichung von Arthur Sherman "In si-tu removal of native oxide from silicon wafers" aus der Fachzeitschrift J. Vac. Sci. Technol. B8(4), Juli/August 1990 Seite 656. Gemäss dieser Veröffentlichung wird vorgeschlagen, den Wasserstoff in einer Hohlkathodenentladung anzuregen bei einer Entladungsspannung von 600 Volt und 100 Milliampere Entladungsstrom. Die hier vorgeschlagene Anordnung löst aber die vorerwähnten Probleme nicht vollumfänglich, da die hohe Energie von etwa 600 Volt zu Defekten der Oberflächenstruktur und zu Wiederbelegungen durch Zerstäubungsvorgänge führen kann. Ein weiterer Fachaufsatz von Y. Kunitsugu I. Suemune "Low temperature cleaning of Si and growth of GaAs on Si by hydrogen plasma assisted metallorganic molecular beam epitaxy" aus Journal of Crystal Growth 95 (1989) 91-95 North-Holland, Amsterdam ist ein weiteres Aetzverfahren für Silizium und Galliumarsenidoberflächen bekannt, welches mit aktiviertem Wasserstoff arbeitet, wobei hier dies Wasserstoffanregung in einem ECR - Plasma erfolgt. Die Erzeugung solcher ECR- Plasmaentladungen mit Mikrowelleneinkopplung ist relativ aufwendig und vor allem für grossflächige Anwendungen schwierig zu realisieren. Bei hohen Anforderungen an die Homogenität der Abtragungsverteilung ist dieses Verfahren besonders aufwendig und bei sehr grossen Dimensionen ist die Realisierung problematisch.

Ein weiteres Verfahren zur Beseitigung von Oxydfilmen auf metallischen Oberflächen ist bekannt geworden aus Patent Abstracts of Japan, Vol. 14, No. 63, (C685) [4006] JP-A-1 287 288. Hier wird vorgeschlagen, einen Oxydfilm von der metallischen Oberfläche durch Implantieren von beschleunigten Wasserstoffionen in die Metalloberfläche zu entfernen, um so die Oberfläche zu reinigen. Die Vorrichtung umfasst eine Ionisationskammer, welche auf Hochvakuum evakuiert ist und in welche Wasserstoffgas durch einen Gaseinlass eingeführt wird. Das Wasserstoffgas wird ionisiert durch die Elektronen, welche von einer heissen Kathode emittiert werden. Die Wasserstoffionen werden durch eine Hochspannungsbeschleunigungselektrode durch eine Öffnung hindurch beschleunigt, so dass ein Ionenstrahl entsteht, welcher auf ein davorliegendes Werkstück auftrifft und somit Ionen implantiert werden. Auch diese Anordnung verwendet vollständig ionisierten Wasserstoff, welchem durch die hohe Beschleunigungsspannung hohe Energien verliehen werden. Hohe Energien führen aber wie bereits erwähnt zu Defekten der Oberflächenstruktur und zu Wiederbelegungen durch Zerstäubungsvorgänge am Substrat.

Die vorliegende Erfindung hat es sich zur Aufgabe gemacht, die Nachteile des Standes der Technik für Abtragungsverfahren beziehungsweise Aetzverfahren zu beseitigen. Das vorgeschlagene Verfahren soll bei einfacher Durchführbarkeit und hohen erzielbaren Abtragungsraten besonders wirtschaftlich arbeiten. Dies wird beim Abtragungsverfahren obengenannter Art durch Vorgehen nach Anspruch 1 erreicht.

Eine heisse Emissionskathode, welche in einer Kathodenkammer angeordnet ist, emittiert Elektronen. Zwischen dieser heissen Kathode und der Vakuumkammer wird eine Niedervoltbogenentladung unterhalten, indem in die Kathodenkammer ein Edelgas als Trägergas für die Plasmaentladung eingelassen wird. Die Kathodenkammer ist mit der Vakuumkammer über eine Öffnung von einigen Millimetern Durchmesser verbunden, so dass die Entladung mit dem Gasstrom in die Vakuumkammer eintritt. Die Kathodenkammer kann zur Steuerung der Ausbreitung der Plasmaentladung wahlweise von der Vakuumkammer isoliert oder über einen Widerstand mit der Vakuumkammer elektrisch verbunden oder auf gleichem Potential wie die Vakuumkammer als Anode geschaltet betrieben werden. Bevorzugt wird die Betriebsweise, wobei die Kathodenkammer mit der Vakuumkammer teilweise über einen Widerstand elektrisch gekoppelt ist und die Vakuumkammer bevorzugt als Anode für die Plasmaentladung wirkt. Aehnliche Verhältnisse können auch erzielt werden wenn die Kathodenkammer elektrisch mit der Vakuumkammer verbunden ist, wobei aber die Innenfläche der Kathodenkammer mit einer Elektrode abgedeckt ist und diese über einen Widerstand mit der Vakuumkammer verbunden ist. Für die Plasmaentladung wird bevorzugterweise ein schweres Edelgas wie Argon oder Neon in die Kathodenkammer eingelassen. Das für den Abtragungsvorgang verantwortliche Wasserstoffgas wird entweder in die Kathodenkammer eingelassen oder kann aber auch direkt in die Vakuumkammer eingelassen werden. Das eingelassende Wasserstoffgas wird durch die Plasmaentladung in einer Weise angeregt, dass die damit beaufschlagten Oberflächen abgetragen werden und dessen gasförmige Abtragungsprodukte über das Vakuumpumpsystem weggeführt werden. Das Wasserstoffgas kann auch wahlweise kombiniert in die Vakuumkammer und in die Kathodenkammer eingelassen werden. Je nach Betriebsweise kann beispielsweise bei hohen Kathodenleistungen die Lebensdauer der heissen Emissionskathode durch Wahl der geeigneten Gasführung entsprechend verlängert werden beziehungsweise die Wirkung des Vorganges optimiert werden.

Als abzutragende Materialien kommen der Wasserstoffreaktion zugängliche Materialien in Frage wie dies gemäss Anspruch 3 vorgeschlagen wird. Speziell geeignet ist das Verfahren zur Abtragung von dünnen Oxydschichten der Halbleitermaterialien, wie beispielsweise der III/V Halbleiter des Periodensystems der Elemente wie beispielsweise Oxyde von Galliumarsenid. Speziell geeignet ist das Verfahren auch für die Abtragung der Oxyde des Siliziums. Zudem eignet sich das Verfahren zur Entfernung von Bor und Schwefel und deren Verbindungen. Beispielsweise kann die unerwünschte Kontamination mit Bor und Schwefel die Funktionseigenschaften von Halbleitern beeinträchtigen. Das Verfahren erlaubt solche unerwünschten Kontaminationen zu korrigieren. Bei diesen Anwendungen werden höchste Anforderungen an die Reinheit gestellt beziehungsweise Kontaminationen durch Wiederbelegung und andere Einbringung von Fremdstoffen müssen vermieden werden. Vermieden werden müssen in der Regel bei diesen Anwendungen auch Strukturdefekte, welche beim Bombardement von energiereichen Teilchen entstehen können. Das Verfahren erlaubt ausserdem die Behandlung bei niedrigeren Temperaturen. Die vorschlagsgemässe Verwendung einer Niedervoltbogenentladung für das Verfahren, erlaubt auf sehr einfache Art eine effektive Anregung des Wasserstoffgases. Die Niedervoltbogenentladung kann mit hohen Entladungsströmen bei geringen Entladungsspannungen grosse Mengen von Wasserstoffgas anregen, was zu einer hohen Abtragungsrate führt und somit zu einer hohen Wirtschaftlichkeit des Verfahrens bei gleichzeitig hoher Reinheit des Verfahrens und geringer Belastung der zu behandelnden Materialien. Ausserdem können die erforderlichen Betriebswerte auf einfache Art verändert und eingestellt werden. Die erreichbaren Betriebswerte gehen aus Anspruch 4 hervor. Bei entprechender Dimensionierung der Kathodenkammer mit ihrer Oeffnung gegen die Vakuumkammer kann ein Arbeitsdruckbereich in der Vakuumkammer von etwa 1 x 10 ⁻⁴ bis 10 Millibar eingestellt werden. Der Totaldruck in der Kathodenkammer kann dabei ohne weiteres eine oder zwei Zehnerpotenzen höher liegen als in der Vakuumkammer. Typische Werte für den Arbeitsbereich sind beispielsweise Entladungsströme von 10 Ampere und Entladungsspannungen von 10 bis 30 Volt bei einem Arbeitsdruck in der Vakuumkammer von 1 x 10 ⁻³ Millibar. Bei 1 Millibar Arbeitsdruck können beispielsweise Werte gefahren werden mit Entladungsströmen von 100 Ampere bei einer Entladungsspannung von etwa 10 bis 20 Volt. Je nach Wahl des Druckes und der Kammerdimensionen können die Werte entsprechend den Erfordernissen variert werden. Bei eingestellten Bogenstromwerten von über 100 Ampere bis einige 100 A können beispielsweise Abtragungsraten von mehr als einem Angström in der Sekunde ohne weiteres erreicht werden, was ein äusserst wirtschaftliches Arbeiten auf grosse Flächen erlaubt, da in der Regel für einen Reinigungsvorgang beispielsweise nur Schichtdicken in der Grössenordnung von etwa 100 Angström abgetragen werden müssen. Substrate können wahlweise wie bei Plasmaprozessen üblich auf ein Massepotential oder auf eine vorgegebene Spannung oder auch isoliert auf Schwebepotential gelegt betrieben werden.

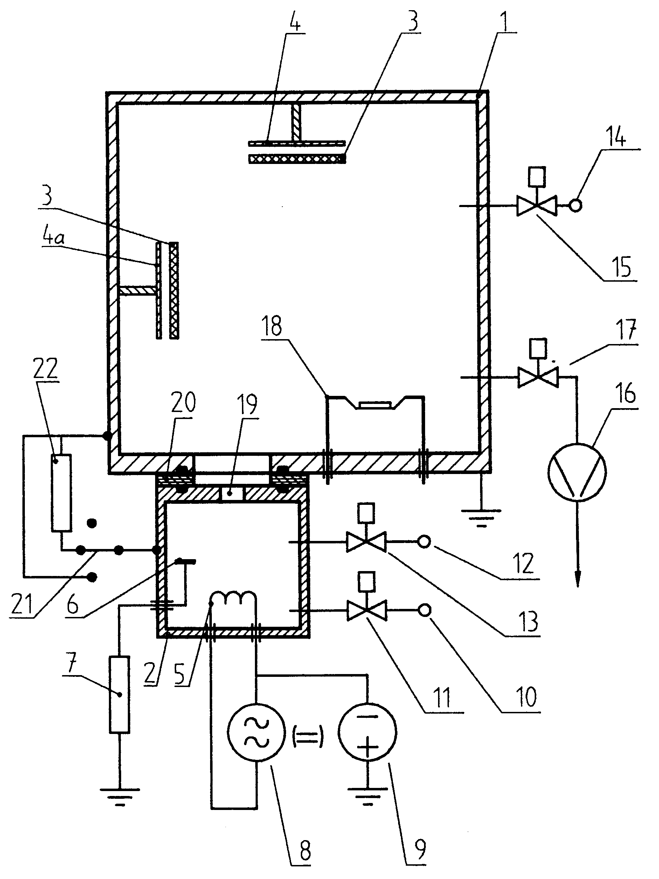

Bei der Beschichtung von Werkstücken mit hochreinen Schichten müssen in der Regel vorgängig die Oberflächen des Werkstückes vor dem Beschichtungsvorgang durch einen Reinigungsschritt abgetragen werden, um die Haftfestigkeit und gegebenenfalls die elektrischen Kontakteigenschaften zwischen der Schicht und der Unterlage reproduzierbar beherrschen zu können. In diesem Fall ist es vorteilhaft in derselben Vakuumkammer in welcher der Reinigungsvorgang stattfindet gleich anschliessend mit Hilfe einer Beschichtungsquelle die Beschichtung vorzunehmen. Gemäss Anspruch 8 können hierzu die bekannten Quellen Verwendung finden, wie Zerstäubungsquellen, Verdampfungsquellen, Ionenplatierungsquellen und oder CVD Gasquellen, wobei diese Quellen auch kombiniert verwendet werden können. Es ist aber auch möglich den Beschichtungsvorgang in separaten Vakuumkammern vorzunehmen und das zu beschichtende Werkstück von der Reinigungskammer in die Beschichtungskammer zu transportieren. Bei diesem Vorgang ist es wichtig, dass zwischen dem Reinigungsschritt und dem Bedampfungsschritt wenig Zeit verloren geht und das Vakuum aufrecht erhalten wird, so dass in der Zwischenzeit keine Rückkontamination der Oberflächen stattfindet. Nach erfolgtem Abtragungsvorgang kann es in gewissen Fällen vorteilhaft sein, wenn für eine nachfolgende Beschichtung gleichzeitig die Kathodenkammer betrieben wird, um den Beschichtungsvorgang zu unterstützen. Beispielsweise kann es erwünscht sein, bei Beschichtungen mit Ladungsträgern zu arbeiten um gewisse Effekte zu erreichen. Hierzu kann die Kathodenkammer mit der entsprechend geführten Plasmaentladung verwendet werden um Ladungsträger wie Elektronen und Ionen bereit zu stellen. Speziell geeignet ist diese Vorrichtung wenn bestimmte Gase reaktiv im Beschichtungsvorgang eingebaut werden sollen.
Das vorgeschlagene Verfahren hat den Vorteil, dass die Abtragungswirkung in der Vakuumkammer nicht auf spezielle Zonen begrenzt ist, sondern grossflächig wirkt. Dies erleichtert die Erfüllung von hohen Anforderungen an die Abtragungshomogenitat. Ausserdem können gleichzeitig grosse Flächen behandelt werden, wodurch eine hohe Wirtschaftlichkeit gegeben ist. Es können ohne weiteres beispielsweise mehrere Werkstücke gleichzeitig behandelt werden oder diese sogar auf bewegbaren Halterungen angeordnet werden wie dies üblich ist bei den für die Beschichtung verwendeten Werkstückhalterungen. Wegen der grossflächigen Wirkung des Verfahrens kann dieses auch angewendet werden, um gleichzeitig oder auch alleine eine kontaminierte Vakuumkammer Innenwand und darin befindliche Teile zu reinigen. Dies ist von grosser Wichtigkeit wenn bei hochreinen Anwendunauch entsprechend gute Vakuumbedingungen gefordert werden. Eine Vakuumkammer kann mit dem Verfahren vorgängig zu den durchzuführenden Vakuumprozessen gereinigt werden. Die Erfindung wird nun anschliessend beispielsweise anhand einer Figur erläutert. Die Figur zeigt schematisch und im Querschnitt eine Darstellung der Vakuumkammeranordnung und der Kathodenkammeranordnung.

An die Vakuumkammer 1 ist über einen Isolator 20 eine Kathodenkammer 2 vakuumdicht angeflanscht. Die Vakuumkammer 1 wird über eine Pumpenanordnung 16, 17 evakuiert. Ueber die Gaseinlassanordnung 14, 15 kann, sofern erforderlich, das Prozessgas Wasserstoff in die Vakuumkammer eingelassen werden. Wenn im Anschluss an den Reinigungsvorgang in derselben Kammer eine Beschichtung vorgesehen ist, können in der Vakuumkammer beispielsweise zusätzlich eine oder mehrere Beschichtungsquellen 18 angeordnet werden. Für die Aufnahme von zu reinigenden Werkstücken 3 ist in der Vakuumkammer eine Werkstückhalterung 4 vorgesehen. Da das Reinigungsverfahren sich über den ganzen Innenraum der Vakuumkammer 1 erstreckt, können Werkstücke über den ganzen Vakuumraum verteilt angeordnet werden, das heisst beispielsweise gegenüber der Kathodenkammeranordnung versetzt wie dies mit der Haltevorrichtung 4a schematisch dargestellt ist. Die Kathodenkammer 2, welche Innenraumdimensionen im Zentimeterbereich aufweist, ist mit einer Oeffnung 19, welche einige Millimeter Durchmesser aufweist gegen die Vakuumkammer 1 geöffnet. In der Kathodenkammer 2 ist eine heisse Emissionskathode 5 angeordnet, welche beispielsweise aus einer Drathwendel besteht oder einer anderen üblichen Bauart einer thermionischen Kathode entspricht. Die Emissionskathode 5 wird mit einer Wechselstrom- oder Gleichstromversorgung 8 so gespiesen, dass die Kathode Emissionstemperatur erreicht. Für die Niedervoltbogenentladung wird zwischen die Emissionskathode und die Vakuumkammer, welche beispielsweise je nach Stellung des Schalters 21 als Anode wirkt, eine Gleichstromversorgung 9 geschaltet. Zur Erzeugung der Niedervoltentladung wird als Trägergas ein Edelgas wie beispielsweise Argon über die Gaseinlassvorrichtung 10, 11 direkt in die Kathodenkammer 2 eingelassen. Wahlweise kann über die Gaseinlassvorrichtung 12, 13 das Prozessgas Wasserstoff eingelassen werden. Die Zündung der Niedervoltbogenentladung kann beispielsweise mit Hilfe einer Hilfselektrode 6, welche über einen Widerstand 7 mit Masse oder Vakuumkammer verbunden ist erfolgen. Die Ausbreitung der Plasmaentladung kann je nach Beschaltung der Anodenseite beeinflusst werden wie dies durch den Wahlschalter 21 schematisch dargestellt möglich ist. Bei direkter Verbindung der Kathodenkammer mit der Vakuumkammer wirkt die Kathodenkammer selbst bevorzugt als Anode so dass die Plasmaentladung auf die Kathodenkammer im wesentlichen konzentriert bleibt. Wird die Kathodenkammer nicht mit der Vakuumkammer verbunden, beziehungsweise ist diese auf Schwebepotential, wirkt die Vakuumkammer als Anode für die Entladung, so dass ein entsprechender Durchgriff der Plasmaentladung in die Vakuumkammer erfolgt. Als bevorzugte Ausführungsform wird ein Widerstand 22 beispielsweise von 22 Ohm zwischen die Vakuumkammer und die Kathodenkammer geschaltet, womit sich die Wirkung der Plasmaentladung in geeigneter Weise einstellen lässt.

Die beschriebene erfindungsgemässe Anordung zur Durchführung des Verfahrens erlaubt einen sehr einfachen Aufbau und die Einstellung von hohen Abtragungsraten, was sich vorteilhaft in der Gesamtwirtschaftlichkeit des Verfahrens auswirkt.

### Beispiele:

Die angeführten Beispiele zeigen typische Betriebswerte für die Einstellung der Niedervoltbogenentladung bei Verwendung von Argongas in der Kathodenkammer zur Unterhaltung der Gasentladung. Je nach Auslegung werden Kathodenwendel verwendet, welche beispielsweise mit einigen 10 A bis über 150 A Heizstrom betrieben werden. Die hierbei notwendigen Werte ergeben sich aus der Dimensionierung der Kathode für welche ein bestimmter Emissionsstrom beziehungsweise Bogenstrom gefordert wird. Bei den angegebenen Beispieleinstellungen wird das Prozessgas Wasserstoff in die Kathodenkammer eingelassen. Die Vakuumkammer wurde mit einer Vakuumpumpanordnung bei einem Saugvermögen von 130 l/s abgepumpt. Grössere Saugleistungen erweitern den Arbeitsbereich auf tiefere Vakuumkammerdrucke bis in den 10 ⁻⁴ mbar Bereich.

| Beispiel | 1 | 2 | 3 |
|---|---|---|---|
| Ar-Fluss [sccm] | 6 | 6 | 95 |
| H-Fluss [sccm] | 14 | 30 | 60 |
| Entladungsstrom [A] | 10 | 100 | 30 |
| Entladungsspannung [V] | 40 | 50 | 55 |
| Totaldruck [mbar] (in Vakuumkammer) | 5 x 10 ⁻³ | 1 x 10 ⁻² | 4 x 10 ⁻¹ |
| Ätzrate [A/sec] (SiO₂ thermisch) | 0,05 | 0,8 | 0,1 |

Bei den angeführten Betriebswerten ist ohne weiteres eine Lebensdauer der Kathode von 150 Stunden und mehr erreichbar. Das Verfahren lässt sich mit geringem apparativem Aufwand bei hohen Reinheitsanforderungen und hohen Abtrageraten durchführen, wodurch ein Produktionsverfahren mit hoher Wirtschaftlichkeit ermöglicht wird.

## Patentansprüche

1. Verfahren zur Abtragung von Material von einer Oberfläche in einer Vakuumkammer (1) bei welchem plasmaaktivierter Wasserstoff verwendet wird dadurch gekennzeichnet, dass die Aktivierung mit Hilfe einer Niedervoltbogenentladung mit einer heissen Emissionskathode (5) angeordnet in einer Kathodenkammer (2) erfolgt, wobei die Kathodenkammer (2) so über eine Öffnung (19) mit der Vakuumkammer (1) verbunden ist, dass zwischen der Vakuumkammer (1) und der Kathodenkammer (2) eine Druckdifferenz beim Einlassen des Arbeitsgases in die Kathodenkammer (2) auftritt, so dass die Plasma-Entladung mit dem Gasstrom in die Vakuumkammer eintritt, wobei die Niedervoltbogenentladung mit einer Entladungsspannung bis 150V zwischen Emissionskathode (5) und Vakuumkammer (1) und/oder Kathodenkammer (2) betrieben wird und als Trägergas für die Entladung ein Edelgas in die Kathodenkammer (2) eingelassen wird.

2. Verfahren nach Anspruch 1 dadurch gekennzeichnet, dass für die Niedervoltbogenentladung als Trägergas vorzugsweise Argon oder Neon in die Kathodenkammer (2) eingelassen wird und dass Wasserstoffgas in die Vakuumkammer (1) und / oder in die Kathodenkammer (2) eingelassen wird.

3. Verfahren nach Anspruch 2 dadurch gekennzeichnet, dass als Material Schichtmaterialien wie Siliziumoxid und/oder Eisenoxide und/oder Oxide der III/V Halbleiter und/oder Kohlenstoffverbindungen und/oder Kohlenstoff und/oder Bor und/oder Schwefel abgetragen werden.

4. Verfahren nach Anspruch 2 oder 3 dadurch gekennzeichnet, dass die Niedervoltbogenentladung bei einem Vakuumkammer-Totaldruck von 1.10⁻⁴ bis 10 mbar betrieben wird und dass Entladungsströme bis 400 A verwendet werden.

5. Verfahren nach Anspruch 4 dadurch gekennzeichnet, dass die Kathodenkammer (2) anschliessend zum Abtragungsvorgang zur Unterstützung eines Beschichtungsvorganges vorzugsweise eines reaktiven verwendet wird.

6. Anordnung zur Durchführung des Verfahrens nach Anspruch 1 bis 4 dadurch gekennzeichnet, dass diese umfasst:
- eine Vakuumkammer (1) mit einer Pumpanordnung (16, 17).
- eine Kathodenkammer (2) mit einer Oeffnung (19) zur Vakuumkammer (1) mit darin eingebauter thermischen Emissionskathode (5).
- eine Stromversorgung (8) zur Heizung der Emissionskathode (5).
- eine Stromversorgung (9) zwischen Emissionskathode (5) und Vakuumkammer (1) und/oder Kathodenkammer (2) zur Speisung der Niedervoltbogenentladung mit einer Spannung bis zu 150V.
- eine Edelgaseinlassvorrichtung (10, 11) einmündend in die Kathodenkammer (2).
- mindestens eine Gaseinlassvorrichtung (12, 13, 14, 15) für die Einführung von Wasserstoff.

7. Anordnung nach Anspruch 6 dadurch gekennzeichnet, dass eine Halteanordnung (4) für mindestens ein Werkstück (3) vorgesehen ist, wobei vorzugsweise mindestens ein Teil der Halteanordnung (4a) gegenüber der Kathodenkammeröffnung (19) versetzt ist.

8. Anordnung nach Anspruch 6 oder 7 dadurch gekennzeichnet, dass eine Beschichtungsquelle (18) wie eine Zerstäubungsquelle und /oder eine Verdampfungsquelle und /oder eine Ionenplatierungsquelle und /oder eine CVD-Gasquelle vorgesehen ist.

9. Verwendung der Anordnung nach Anspruch 6 zur Reinigung der Vakuumkammer.

## Claims

1. Method to remove material from a surface in a vacuum chamber (1) where plasma activated hydrogen is used and characterized in that the activation takes place by means of a low voltage arc discharge with a hot emission cathode (5) placed in a cathode chamber (2), where the cathode chamber (2) is linked to the vacuum chamber (1) by an opening (19) so that between said vacuum chamber (1) and said cathode chamber (2) a pressure difference occurs when the working gas is let into the cathode chamber (2) so that the plasma discharge enters with the gas flow into the vacuum chamber whereby the low voltage arc discharge is operated with a discharge voltage up to 150V between the emission cathode (5) and the vacuum chamber (1)and/or cathode chamber (2) and a noble gas functioning as a carrier gas for the discharge is let into the cathode chamber (2)

2. Method as claimed in claim 1 characterized in that for the low voltage arc discharge preferably argon or neon are used as carrier gas to be let into the cathode chamber (2) and where hydrogen is let into the vacuum chamber (1) and/or the cathode chamber (2).

3. Method as claimed in claim 2 characterized in that the materials which are removed are thin film materials such as silicon oxyde and/or iron oxydes and/or oxydes of the III/V semiconductors and/or carbon alloys and /or carbon and/or boron and/or sulfur.

4. Method as claimed in claim 2 or claim 3 characterized in that the low voltage arc discharge is operated with a total pressure of 1.10⁻⁴ through 10 mbar in the vacuum chamber and where discharge currents of up to 400A are used.

5. Method as claimed in claim 4 characterized in that the cathode chamber (2) subsequently to the removing is used to support a deposition procedure, preferably a reactive deposition procedure.

6. Arrangement for the operation of the method as of claim 1 through 4 consisting of :
- a vacuum chamber (1) with a pumping arrangement (16,17)
- a cathode chamber (2) with an opening (19) to the vacuum chamber (1) with an integrated thermic emission cathode (5)
- a power supply (8) to heat the emission cathode (5)
- a power supply (9) between the emission cathode (5) and the vacuum chamber (1) and/or the cathode chamber (2) to supply the low voltage arc discharge with a voltage of up to 150V.
- a noble gas inlet (10, 11) joining into the cathode chamber (2)
- at least one gas inlet (12, 13, 14, 15) to let in hydrogen.

7. Arrangement as claimed in claim 6 characterized in that there is a holding device (4) for at least one workpiece (3) where preferably at least a part of the holding device (4a) is displaced in relation to the cathode chamber opening (19).

8. Arrangement as claimed in claim 6 or 7 characterized in that there is used a coating source (18) such as a sputtering source and/or an evaporation source and/or an ion plating source and/or a CVD gas source.

9. Use of the arrangement as claimed in claim 6 for the cleaning of the vacuum chamber.

## Revendications

1. Procédé d'enlèvement de matière à partir d'une surface dans une chambre de vide (1) dans lequel est utilisé de l'hydrogène activé par plasma, caractérisé en ce que l'activation est réalisée à l'aide d'une décharge d'arc à basse tension par une cathode d'émission chaude (5) disposée dans la chambre (2) de cathodes, la chambre (2) de cathodes étant reliée par une ouverture (19) à la chambre de vide (1) d'une manière telle qu'une différence de pression apparaît entre la chambre de vide (1) et la chambre de cathodes (2) lors de l'introduction du gaz de travail dans la chambre de cathodes (2), de sorte que la décharge de plasma entre avec le courant gazeux dans la chambre de vide, la décharge d'arc à basse tension étant effectuée à une tension de décharge pouvant atteindre 150 V entre la cathode d'émission (5) et la chambre de vide (1) et/ou la chambre de cathodes (2), et un gaz rare étant introduit dans la chambre de cathodes (2) en tant que gaz porteur pour la décharge.

2. Procédé selon la revendication 1, caractérisé en ce que de l'argon ou du néon est de préférence introduits comme gaz porteur dans la chambre de cathodes (2) pour la décharge d'arc à basse tension et en ce que de l'hydrogène gazeux est introduit dans la chambre de vide (1) et/ou dans la chambre de cathodes (2).

3. Procédé selon la revendication 2, caractérisé en ce que la matière enlevée consiste en matières en couches comme de l'oxyde de silicium et/ou des oxydes de fer et/ou des oxydes des semi-conducteurs III/V et/ou des combinaisons carbonées et/ou du carbone et/ou du bore et/ou du soufre.

4. Procédé selon la revendication 2 ou 3, caractérisé en ce que la décharge d'arc à basse tension se produit sous une pression totale de chambre de vide comprise entre 1,10⁻⁴ et 10 mbar et en ce que des courants de décharge pouvant atteindre 400 A sont utilisés.

5. Procédé selon la revendication 4, caractérisé en ce que la chambre de cathodes (2) est utilisée après le processus d'enlèvement pour permettre un procédé de revêtement, de préférence un procédé réactif.

6. Dispositif de mise en oeuvre du procédé selon l'une des revendications 1 à 4, caractérisé en ce que celui-ci comprend:
- une chambre de vide (1) pourvue d'un agencement de pompe (16, 17).
- une chambre de cathodes (2) dans laquelle une cathode d'émission thermique (5) est montée et une ouverture (19) est ménagée vers la chambre de vide (1).
- une alimentation en courant (8) pour chauffer la cathode d'émission (5).
- une alimentation en courant (9) entre la cathode d'émission (5) et la chambre de vide (1) et/ou la chambre de cathodes (2) pour alimenter la décharge d'arc à basse tension à une tension pouvant atteindre 150 V.
- un dispositif d'introduction de gaz rare (10, 11) qui débouche dans la chambre de cathodes (2).
- au moins un dispositif d'introduction de gaz (12, 13, 14, 15) pour l'introduction d'hydrogène.

7. Dispositif selon la revendication 6, caractérisé en ce qu'il est prévu un dispositif de maintien (4) d'au moins une pièce à traiter (3), au moins une partie du dispositif de maintien (4a) étant de préférence décalée par rapport à l'ouverture (19) de la chambre de cathodes.

8. Dispositif selon la revendication 6 ou 7, caractérisé en ce qu'il est prévu une source de revêtement (18), par exemple une source de pulvérisation cathodique et/ou une source d'évaporation et/ou une source de plaquage ionique et/ou une source de gaz pour dépôt chimique en phase vapeur.

9. Utilisation du dispositif selon la revendication 6 pour nettoyer la chambre de vide.
